# EUROPEAN PATENT APPLICATION

(11) **EP 4 772 898 A1**
(43) Date of publication of application: **08.07.2026**
(21) Application number: 24883843.5
(22) Date of filing: 08.05.2024
(51) Int. Cl.: G01R 31/385, G01R 31/396, G01R 31/36, H01M 10/42

(54) **NAIL PENETRATION TEST DEVICE**

(30) Priority: 02.11.2023 CN 202322955983 U
(71) Applicant: Contemporary Amperex Technology Co., Limited, Ningde, Fujian 352100 (CN)
(72) Inventor: LIAO, Guolong, Ningde, Fujian 352100 (CN); JIA, Fengqiu, Ningde, Fujian 352100 (CN); CHEN, Jinda, Ningde, Fujian 352100 (CN); FENG, Gaoyou, Ningde, Fujian 352100 (CN); REN, Shaoteng, Ningde, Fujian 352100 (CN); GUO, Lixin, Ningde, Fujian 352100 (CN)
(74) Representative: Gong, Jinping
(86) International application number: PCT/CN2024/091718
(87) International publication number: WO 2025/091830

(57) **Abstract**

Disclosed is a nail penetration test device (100), which can improve the performance of nail penetration tests. The device (100) includes: a voltage acquisition module (130), including a first connection port and a second connection port, where the first connection port is connected to a nail, and the second connection port is connected to a first electrode terminal of a battery cell (20); and a nail mechanism (120), configured to control the nail to move toward the battery cell (20), where the voltage acquisition module (130) is configured to detect a voltage between the nail and the first electrode terminal during the movement of the nail toward the battery cell (20), and the voltage is used to determine an initial penetration position of the nail on the battery cell (20).

## Description

### CROSS-REFERENCE TO RELATED APPLICATIONS

The present application claims priority to Chinese Patent Application No. 202322955983.1, filed on November 02, 2023 and entitled "Nail Penetration Test Device", which is incorporated herein by reference in its entirety.

### TECHNICAL FIELD

The present application relates to the field of batteries, and in particular, to a nail penetration test device.

### BACKGROUND

A nail penetration test for a battery, also known as an internal short-circuit test, is used to evaluate a safety risk of a battery cell in the event of an internal short circuit. In general, the test involves driving a nail into the battery cell to evaluate a safety risk arising from a short circuit between an electrode sheet in the battery cell and the nail. Enhancing performance of the nail penetration test has become an urgent issue to be addressed.

### SUMMARY

Embodiments of the present application provide a nail penetration test device, which can improve the performance of nail penetration tests.

According to a first aspect, a nail penetration test device is provided, where the device comprises: a voltage acquisition module, comprising a first connection port and a second connection port, where the first connection port is connected to a nail, and the second connection port is connected to a first electrode terminal of a battery cell; and a nail mechanism, configured to control the nail to move toward the battery cell, where the voltage acquisition module is configured to detect a voltage between the nail and the first electrode terminal during the movement of the nail toward the battery cell, and the voltage is used to determine an initial penetration position of the nail on the battery cell.

Optionally, the battery cell comprises a first electrode sheet and a second electrode sheet alternately stacked with each other, an electrode sheet at an outermost layer is the second electrode sheet, the first electrode sheet and the second electrode sheet have opposite polarities, the first electrode terminal is an electrode terminal connected to the first electrode sheet, and the voltage is used to determine the initial penetration position of the nail on the battery cell.

The nail mechanism in the nail penetration test device can fix the nail, and control the nail to move toward the battery cell. During the movement of the nail, the voltage acquisition module detects the voltage between the nail and the first electrode terminal connected to the first electrode sheet. When the nail touches or penetrates the second electrode sheet at the outermost layer, the voltage acquisition module can detect that the voltage between the nail and the first electrode terminal has changed significantly. Therefore, the initial penetration position of the nail on the battery cell may be determined based on a change of the voltage between the nail and the first electrode terminal, and the initial penetration position is used as a start point to control the nail to further move inside the battery cell to a predetermined depth. In this way, with the device, the initial penetration position of the nail on the battery cell can be accurately determined by using a relationship between a physical structure of the battery cell and a voltage without complex modification on the battery cell, thereby completing the nail penetration test, and meeting test requirements for different penetration depths while improving test precision.

In some possible implementations, the device further comprises: a carrying mechanism, configured to carry a battery cell to be tested, and adjust a position of the battery cell in a first direction; where the nail mechanism is specifically configured to control the nail to move toward the battery cell along a second direction, and the second direction is perpendicular to the first direction. With cooperation between the carrying mechanism and the nail mechanism, a penetration position of the nail on a surface of the battery cell can be effectively positioned.

In some possible implementations, the nail mechanism comprises a connecting member, a clamping member, and a first pushing member, the clamping member and the first pushing member are respectively disposed on both sides of the connecting member along the second direction, the clamping member is configured to clamp the nail, and the first pushing member is disposed to move along the second direction to push the connecting member, the clamping member, and the nail to move along the second direction.

In the embodiments, the nail mechanism comprises the clamping member for clamping the nail, the first pushing member for pushing the nail to move, and the connecting member for connecting and disposing the clamping member and the first pushing member. As such, the first pushing member can push the connecting member, the clamping member, and the nail to move toward the battery cell when being driven.

In some possible implementations, the nail mechanism further comprises a first guiding member, the first guiding member is disposed on a side, of the connecting member, on which the first pushing member is located, and the first guiding member is configured to constrain the first pushing member to move along the second direction. With the first guiding member disposed, the first pushing member can be provided with a specific anti-tilting capability, and reliability thereof can be improved, so that the nail can penetrate the battery cell vertically or approximately vertically along the second direction, instead of penetrating the battery cell obliquely.

In some possible implementations, the nail mechanism further comprises a force value sensor, and the force value sensor is disposed between the clamping member and the connecting member, and is configured to detect an acting force generated during the penetration of the nail into the battery cell.

The force value sensor can detect the acting force generated during the penetration of the nail into the battery cell, to assist in analyzing a change of an acting force generated by an electrode sheet on the nail during the nail penetration test, thereby expanding a parameter range in the nail penetration test based on a force value change, so that test data analysis is more comprehensive.

The force value sensor may have any shape. For example, the force value sensor comprises a first bending portion and a second bending portion that are disposed along the second direction, the first bending portion is connected to the connecting member, and the second bending portion is connected to the clamping member.

In some possible implementations, the device further comprises a housing, where the nail mechanism further comprises a first fixing member, the first fixing member is configured to fix the first guiding member to a first wall of the housing, and the first wall is perpendicular to the second direction. Fixing the first guiding member to the first wall of the housing by using the first fixing member enables the first guiding member to accurately constrain the first pushing member to move in the second direction.

In some possible implementations, the carrying mechanism comprises a carrying platform and a second pushing member, and the second pushing member is disposed to move along the first direction to push the carrying platform and the battery cell to move along the first direction.

In the embodiments, the carrying mechanism comprises the carrying platform for carrying the battery cell and the second pushing member for pushing the battery cell to move. As such, the second pushing member can push the carrying platform and the battery cell to move along the first direction when being driven.

In some possible implementations, the carrying mechanism further comprises a second guiding member, the second guiding member is disposed on a side, of the carrying platform, on which the second pushing member is located, and the second guiding member is configured to constrain the second pushing member to move along the first direction.

With the second guiding member disposed, the second pushing member can be provided with a specific anti-tilting capability, and reliability thereof can be improved, so that the battery cell is not shifted from the first direction, thereby enabling the nail to penetrate the battery cell vertically or approximately vertically, instead of penetrating the battery cell obliquely.

In some possible implementations, the carrying platform is provided with a hole position, the hole position is configured to mount a limiting member, and the limiting member is configured to limit a position of the battery cell. With the hole position disposed to mount the limiting member, the battery cell can be fixed to the carrying platform, thereby improving stability during the nail penetration test.

In some possible implementations, the device further comprises a housing, where the carrying mechanism further comprises a second fixing member, the second fixing member is configured to fix the second guiding member to a second wall of the housing, and the second wall is perpendicular to the first direction. Fixing the second guiding member to the second wall of the housing by using the second fixing member enables the second guiding member to accurately constrain the second pushing member to move in the second direction.

In some possible implementations, the device further comprises a housing and a protective panel, where the protective panel is disposed between the battery cell and a third wall of the housing. The protective panel can protect the third wall, of the housing, that is close to the battery cell, so that emissions such as residues and smoke generated by the battery cell during the test can be prevented from being attached to the third wall to some extent, thereby reducing damage to the third wall.

In some possible implementations, the protective panel is detachably connected to the third wall, to facilitate replacement of the protective panel.

In some possible implementations, the protective panel is provided with a counterbore, the counterbore is configured to dispose a fixing member, the fixing member is configured to fix the protective panel and the third wall, and the third wall is perpendicular to the second direction. Designing the counterbore is beneficial to reducing a probability of interference between the protective panel and the battery cell.

In some possible implementations, the protective panel is provided with an engraved mark, and the engraved mark is configured to position the battery cell. The visible engraved mark on the protective panel facilitates positioning of the battery cell. This helps testing personnel determine a positional relationship between the battery cell and the protective panel, for example, determine whether the battery cell is roughly located in a central region of the protective panel.

In some possible implementations, the battery cell further comprises an enclosure, the enclosure is configured to accommodate the first electrode sheet and the second electrode sheet, and an avoidance hole is disposed at a position on the enclosure for penetration by the nail. The avoidance hole can effectively avoid the nail, so as to facilitate penetration of the nail into an electrode sheet.

In some possible implementations, the device further comprises: a control module, connected to the voltage acquisition module and the nail mechanism, and configured to determine the initial penetration position based on the voltage, and based on the initial penetration position, drive the nail mechanism to move along the second direction, so that the nail penetrates the battery cell to a predetermined depth.

The control module may obtain voltage information of a test process from the voltage acquisition module, and may further drive the nail mechanism and the carrying mechanism, so that the nail mechanism and the carrying mechanism move in a corresponding direction, thereby making the nail accurately penetrate the battery cell.

### BRIEF DESCRIPTION OF THE DRAWINGS

In order to more clearly illustrate the technical solutions of the embodiments of the present application, the drawings required to be used in the embodiments of the present application will be briefly introduced below. Apparently, the drawings described below are only some embodiments of the present application. For persons of ordinary skill in the art, other drawings can also be obtained from the drawings without creative work.
FIG. 1 is a schematic diagram of a nail penetration test;
FIG. 2 is a schematic diagram of an initial penetration position of a nail penetration test;
FIG. 3 is a schematic structural diagram of a nail penetration test device according to an embodiment of the present application;
FIG. 4 is a schematic diagram of an electrode sheet stack of a possible battery cell according to an embodiment of the present application;
FIG. 5 is a schematic diagram of a possible process of a nail penetration test according to an embodiment of the present application;
FIG. 6 is a possible schematic structural diagram of a nail mechanism according to an embodiment of the present application;
FIG. 7 is a possible schematic structural diagram of a carrying mechanism according to an embodiment of the present application; and
FIG. 8 is a possible schematic structural diagram of a protective panel according to an embodiment of the present application.

### DETAILED DESCRIPTION OF PREFERRED EMBODIMENTS

The following further describes implementations of the present application in detail with reference to the accompanying drawings and embodiments. The following detailed description of the embodiments and the accompanying drawings are used to describe the principles of the present application by way of example, but are not intended to limit the scope of the present application, that is, the present application is not limited to the described embodiments.

Unless otherwise defined, all technical and scientific terms used in the present application have the same meaning as commonly understood by a person skilled in the art of the present application. In the present application, the terms used in the description of the present application are only used for describing specific embodiments and are not intended to limit the present application, and the terms "comprise", "have", and any variations thereof in the description and claims of the present application and the above description of the drawings are intended to cover a non-exclusive inclusion. The terms "first", "second", and the like in the specification and claims of the present application or in the accompanying drawings are used to distinguish between different objects, and are not used to describe a specific sequence or a primary-secondary relationship. "Perpendicular" is not perpendicular in the strict sense, but is within an allowable range of error. "Parallel" is not parallel in the strict sense, but is within an allowable range of error.

An "embodiment" in the present application means that a specific feature, structure, or characteristic described with reference to the embodiment may be included in at least one embodiment of the present application. The phrase in various places in the description does not necessarily all refer to the same embodiment, or a separate or alternative embodiment mutually exclusive of other embodiments. A person skilled in the art explicitly and implicitly understands that the described embodiments in the present application may be combined with another embodiment.

In the description of the present application, it should be noted that, unless explicitly specified and defined otherwise, the terms "mount", "couple", "connect", and "attach" are to be understood in a broad sense. For example, the terms may indicate a fixed connection, a detachable connection, or an integral connection, and may indicate a direct connection or an indirect connection implemented via an intermediate medium, or internal communication between two elements. A person skilled in the art can understand specific meanings of these terms in the present application according to specific situations.

The term "and/or" in the present application is only an associative relationship for describing associated objects, indicating that three relationships may be present. For example, A and/or B may indicate three cases: presence of only A; presence of both A and B; and presence of only B. In addition, the symbol "/" in the present application generally represents an "or" relationship between associated objects.

In the embodiments of the present application, the same reference numerals denote the same component, and a detailed description of the same component is omitted in different embodiments for brevity. It should be understood that the dimensions of various components, such as the thickness, length, and width, and the dimensions of an integrated device, such as the overall thickness, length, and width, in the embodiments of the present application shown in the figures are merely illustrative and should not be construed as limiting the present application.

A battery is usually a single physical module that includes one or more battery cells for providing a higher voltage and capacity. For example, the battery may include a battery module, a battery pack, or the like. Generally, the battery further includes a case for encasing one or more battery cells. The case can prevent liquids or other foreign objects from affecting the charging or discharging of the battery cells.

The battery cell includes an electrode assembly and an electrolyte. The electrode assembly includes a positive electrode sheet, a negative electrode sheet, and a separator located between the positive electrode sheet and the negative electrode sheet. Working of the battery cell mainly relies on migration of metal ions between the positive electrode sheet and the negative electrode sheet. The positive electrode sheet includes a positive electrode current collector and a positive electrode active substance layer. The positive electrode active substance layer is coated on a surface of a body portion of the positive electrode current collector. A part, of the positive electrode current collector, uncoated with the positive electrode active substance layer protrudes from the body portion of the positive electrode current collector to serve as a positive electrode tab. A lithium-ion battery is used as an example, for which, the positive electrode current collector may be made of aluminum, and a positive electrode active substance may be lithium cobalt oxide, lithium iron phosphate, ternary lithium, lithium manganate oxide, or the like. The negative electrode sheet includes a negative electrode current collector and a negative electrode active substance layer. The negative electrode active substance layer is coated on a surface of a body portion of the negative electrode current collector. A part, of the negative electrode current collector, uncoated with the negative electrode active substance layer protrudes from the body portion of the negative electrode current collector to serve as a negative electrode tab. The negative electrode current collector may be made of copper, and a negative electrode active substance may be carbon, silicon, or the like. To reduce a possibility that a large current passes through and fusing occurs, a plurality of positive electrode tabs may be stacked together, and a plurality of negative electrode tabs may be stacked together.

To simulate an internal short circuit scenario of a battery caused by contamination by conductive particles or the like, a thin nail with a diameter of about 1 millimeter may be used to penetrate an electrode sheet in a battery cell to cause an internal short circuit of the battery cell, thereby evaluating a safety risk of the battery cell upon the internal short circuit. This process is commonly referred to as a nail penetration test, a shallow penetration test, or an internal short-circuit test of the battery. It can be understood that a penetration position of a nail on an electrode sheet corresponds to a body portion, of a current collector of the electrode sheet, coated with the positive electrode active substance layer.

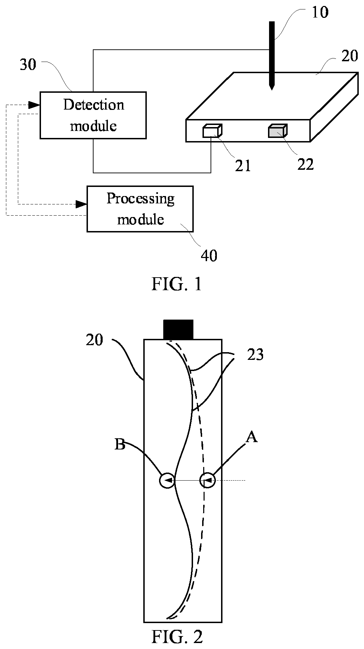

For example, as shown in FIG. 1, a nail 10 is connected to a first electrode terminal 21 of a battery cell 20, and the first electrode terminal 21 and a second electrode terminal 22 have opposite polarities. For example, the first electrode terminal 21 is a negative electrode terminal and the second electrode terminal 22 is a positive electrode terminal, or the first electrode terminal 21 is a positive electrode terminal and the second electrode terminal 22 is a negative electrode terminal. The battery cell 20 includes a positive electrode sheet and a negative electrode sheet alternately stacked with each other. If the positive electrode sheet is at an outermost layer, the first electrode terminal 21 connected to the nail 10 is the negative electrode terminal; or if the negative electrode sheet is at an outermost layer, the first electrode terminal 21 connected to the nail 10 is the positive electrode terminal.

In an example with the negative electrode sheet being at the outermost layer and the first electrode terminal 21 being the positive electrode terminal, the nail 10 is connected to the first electrode terminal 21. During movement of the nail 10 toward the battery cell 20, before the nail 10 moves to touch or penetrate the negative electrode sheet at the outermost layer, no loop is formed among the negative electrode sheet at the outermost layer, the nail 10, a detection module 30, and the first electrode terminal 21. At a moment when the nail 10 moves to touch or penetrate the negative electrode sheet at the outermost layer, a loop is formed among the negative electrode sheet at the outermost layer, the nail 10, the detection module 30, and the first electrode terminal 21, and the detection module 30 can detect a voltage between the positive electrode sheet and the negative electrode sheet. As the nail 10 further penetrates the battery cell 20, an internal short circuit is formed between the positive electrode sheet and the negative electrode sheet through the nail 10, and the detection module 30 can detect that a voltage drop occurs between the nail 10 and the first electrode terminal 21. In this case, the nail 10 stops moving, and it is considered at this time that the nail 10 penetrates the first layer of negative electrode sheet and positive electrode sheet of the battery cell 20.

Generally, a requirement of the nail penetration test is that the nail 10 penetrates one layer of positive electrode sheet and negative electrode sheet in the battery cell 20. Based on a change in a voltage between the nail 10 and the first electrode terminal 21 detected by the detection module 30, a processing module 40 may determine whether the nail 10 penetrates one layer of positive electrode sheet and negative electrode sheet of the battery cell 20.

However, in other scenarios, it is also desirable that the testing nail 10 penetrates a plurality of layers of positive electrode sheets and negative electrode sheets in the battery cell 20. Since the positive electrode sheet and the negative electrode sheet are stacked and loose to a certain extent, for example, as shown in FIG. 2, when the nail 10 penetrates the battery cell 20, an electrode sheet 23 is tightly pressed in a region near a penetration position. Therefore, there is a deviation between a theoretical initial position A of the nail on the battery cell 20 and an actual initial position B of the nail 10 on the battery cell 20. Since the initial penetration position of the nail 10 cannot be accurately determined, it is impossible to identify a voltage drop generated when a short circuit is induced between the plurality of layers of positive electrode sheets and negative electrode sheets through the nail 10, and thus impossible to meet more test requirements.

Therefore, the present application proposes a solution of a nail penetration test, aiming to accurately determine an initial penetration position of a nail on a battery cell by using a relationship between a physical structure of the battery cell and a voltage, so as to control a penetration depth or the number of penetration layers of the nail into the battery cell based on the initial penetration position, thereby meeting different test requirements.

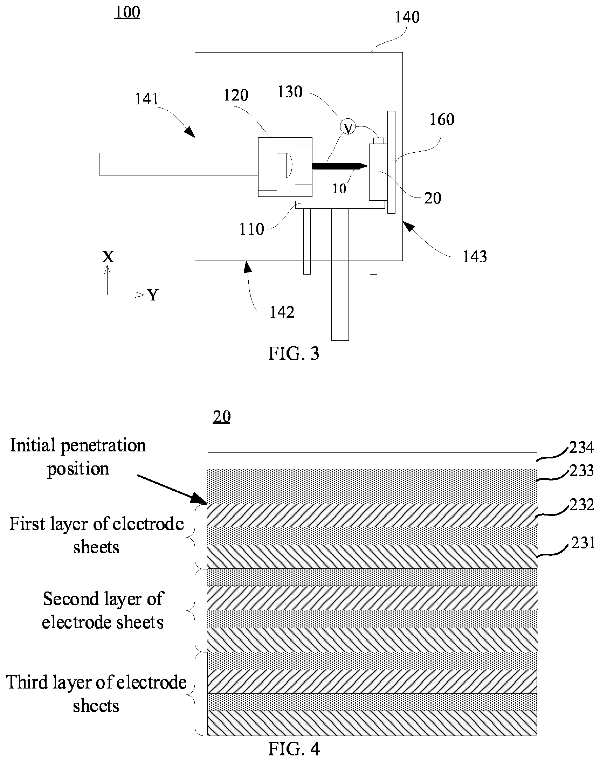

As an example, FIG. 3 shows a schematic structural diagram of a nail penetration test device according to an embodiment of the present application. Optionally, a battery cell 20 to be tested may include, for example, a secondary battery such as a sodium-ion battery or a lithium-ion battery, a structure thereof includes a first electrode sheet and a second electrode sheet alternately stacked with each other, an electrode sheet at an outermost layer is the second electrode sheet, and the first electrode sheet and the second electrode sheet have opposite polarities. The device 100 may be applied to nail penetration tests for battery cells 20 of various structural types. The battery cells 20 may have a winding structure or a stacked structure, and may also be a cylindrical battery cell or a pouch battery cell. These battery cells may all be tested by using the nail penetration test device 100 provided in this embodiment of the present application.

As shown in FIG. 3, the device 100 includes a nail mechanism 120 and a voltage acquisition module 130. The voltage acquisition module 130 is connected between a nail 10 and a first electrode terminal of the battery cell 20. For example, the voltage acquisition module 130 includes a first connection port and a second connection port, the first connection port is configured to connect to the nail 10, and the second connection port is configured to connect to the first electrode terminal of the battery cell 20. The first electrode terminal is an electrode terminal, on the battery cell 20, connected to the first electrode sheet. The nail mechanism 120 is configured to control the nail 10 to move toward the battery cell 20, where the voltage acquisition module 130 is configured to detect a voltage between the nail 10 and the first electrode terminal during the movement of the nail 10 toward the battery cell 20.

Optionally, the voltage is used to determine a penetration depth of the nail into the battery cell 20, so that the penetration depth of the nail 10 into the battery cell 20 reaches a predetermined depth. For example, the voltage may be used to determine an initial penetration position of the nail 10 on the battery cell 20.

The initial penetration position is a position of the nail 10 when the nail 10 starts to penetrate the battery cell 20. At this point, the nail 10 may touch or have slightly penetrated the second electrode sheet at the outermost layer. In other words, the initial penetration position may be regarded as a position of the nail 10 when the nail 10 touches or penetrates the second electrode sheet at the outermost layer. For example, the initial penetration position may be a position of a tip of the nail 10, a position of a tail of the nail 10, or a position of another part of the nail 10. Then, the nail 10 may be controlled by the nail mechanism 120 to further move from the initial penetration position as a start point, until the nail penetrates the battery cell 20 to the predetermined depth.

Specifically, one end of the voltage acquisition module 130 is connected to the nail 10 through a voltage acquisition line, and the other end is connected to an electrode terminal corresponding to the first electrode sheet through a voltage acquisition line. At this time, the nail 10, the voltage acquisition module 130, and the electrode terminal form a path. When the nail 10 penetrates an electrode sheet of the battery cell 20, the path forms a loop, so that a voltage is measured.

In some embodiments, the device 100 further includes a carrying mechanism 110. The carrying mechanism 110 is configured to carry the battery cell 20, and adjust a position of the battery cell 20 in a first direction X; where the nail mechanism 120 is specifically configured to control the nail 10 to move toward the battery cell along a second direction Y.

The second direction Y is perpendicular to the first direction X. The nail 10 moves toward the battery cell 20 along the second direction Y. Generally, the second direction Y is perpendicular or approximately perpendicular to a surface of an electrode sheet of the battery cell 20. In other words, the nail 10 vertically or approximately vertically penetrates the electrode sheet of the battery cell 20.

With cooperation between the carrying mechanism 110 and the nail mechanism 120, a penetration position of the nail 10 on a surface of the battery cell 20 can be effectively positioned.

A positive electrode sheet of the battery cell 20 is connected to a positive electrode terminal, and a negative electrode sheet is connected to a negative electrode terminal. When the electrode sheet at the outermost layer of the battery cell 20 is configured as the negative electrode sheet, the voltage acquisition module 130 may be connected between the nail 10 and the positive electrode terminal of the battery cell 20 to detect a voltage between the nail 10 and the positive electrode terminal during the movement of the nail 10 toward the battery cell 20, and the voltage between the nail 10 and the positive electrode terminal is a voltage between the nail 10 and an overall positive electrode of the battery cell 20. When the electrode sheet at the outermost layer of the battery cell 20 is configured as the positive electrode sheet, the voltage acquisition module 130 may be connected between the nail 10 and the negative electrode terminal of the battery cell 20 to detect a voltage between the nail 10 and the negative electrode terminal during the movement of the nail 10 toward the battery cell 20, and the voltage between the nail 10 and the negative electrode terminal is a voltage between the nail 10 and an overall negative electrode of the battery cell 20.

The nail mechanism 120 in the nail penetration test device 100 may fix the nail 10 and control it to move toward the battery cell 20. The fixing here may be, for example, clamping, welding, pasting, or the like. During the movement of the nail 10, the voltage acquisition module 130 detects the voltage between the nail 10 and the first electrode terminal. When the nail 10 touches or penetrates the second electrode sheet at the outermost layer, a loop is formed among the second electrode sheet at the outermost layer, the nail 10, a detection module 30, and the first electrode terminal 21, and the voltage acquisition module 130 may detect that the voltage between the nail 10 and the first electrode terminal 21 changes. Therefore, the initial penetration position of the nail 10 on the battery 20 may be determined based on a change of the voltage between the nail 10 and the first electrode terminal, and the initial penetration position is used as a start point to control the nail 10 to further move inside the battery cell 20 to the predetermined depth. In this way, with the device 100, the initial penetration position at which the nail starts to penetrate the battery cell 20 can be determined by using a relationship between a physical structure of the battery cell 20 and a voltage without complex modification on the battery cell 20, so as implement the nail penetration test on a predetermined number of layers or the predetermined depth within the battery cell 20, thereby meeting test requirements for different numbers of penetration layers and different depths.

For example, in a process of the nail mechanism 120 controlling the nail 10 to move toward the battery cell 20, when the voltage acquisition module 130 detects that the voltage between the nail 10 and the first electrode terminal changes abruptly and exceeds a preset voltage, a position reached by the nail 10 at a moment when the voltage between the nail 10 and the first electrode terminal exceeds the preset voltage may be used as the initial penetration position of the nail 10 on the battery cell 20, and the nail 10 may be controlled by the clamping mechanism 120 to further move inside the battery cell 20 from the initial penetration position as a start point to the predetermined depth.

In some embodiments, the device 100 further includes a housing 140. The housing 140 is configured to accommodate the carrying mechanism 110, the nail mechanism 120, the voltage acquisition module 130, and the like.

In some embodiments, the device 100 further includes a control module. The control module is connected to the voltage acquisition module 130 and the nail mechanism 120, and is configured to determine the initial penetration position based on the voltage detected by the voltage acquisition module 130, and based on the initial penetration position, drive the nail mechanism 120 to move along the second direction Y, so that the nail 10 penetrates the battery cell 20 to the predetermined depth.

The control module may be further connected to the carrying mechanism 110, and is configured to drive the carrying mechanism 110 to move along the first direction X, so as to move the battery cell 20 on the carrying mechanism 110 to an appropriate position.

It can be seen that the control module may obtain voltage information of a test process from the voltage acquisition module 130, and may further drive the nail mechanism 120 and the carrying mechanism 110, so that the nail mechanism 120 and the carrying mechanism 110 move in a corresponding direction, thereby making the nail 10 accurately penetrate the battery cell 20.

Theoretically, the preset voltage may be any voltage value from 0 V to an open-circuit voltage of the battery cell 20. That is, as long as a change in voltage from 0 is detected, the initial penetration position can be determined. When sensitivity of a voltage detection device is sufficient, a smaller preset voltage is preferred. However, in practical applications, optionally, the preset voltage may be set to be greater than or equal to 0.5 V and less than or equal to 1.5 V, greater than or equal to 0.6 V and less than or equal to 1.4 V, greater than or equal to 0.7 V and less than or equal to 1.3 V, greater than or equal to 0.8 V and less than or equal to 1.2 V, or greater than or equal to 0.9 V and less than or equal to 1.1 V.

In this embodiment of the present application, the preset voltage being 1 V is used as an example. During the movement of the nail 10 toward the battery cell 20, if the voltage between the nail 10 and the first electrode terminal changes abruptly and exceeds the preset voltage, it is considered that the nail 10 touches or penetrates the second electrode sheet at the outermost layer. In this case, a position of the nail 10 at this point may be used as the initial penetration position, and based on the initial penetration position, the nail 10 is controlled to further move for a specific distance before being stopped. The distance by which the nail 10 further moves from the initial penetration position is equal to the predetermined depth described above.

If the preset voltage is relatively large, test precision is relatively poor, and the initial penetration position cannot be positioned in time when the nail 10 touches or penetrates the second electrode sheet at the outermost layer. If the preset voltage is relatively small, a higher requirement is imposed on sensitivity of a test device, and a test result is susceptible to interference caused by another factor in the test. Therefore, after repeated experimental verification, it has been determined that when the preset voltage falls within the above voltage range, a deviation of the initial penetration position is within one layer, thereby meeting test requirements of most battery cells. Preferably, the preset voltage may be set to 1 V. Certainly, when the sensitivity of the test device is sufficiently high, the preset voltage may alternatively be set to a smaller value, such as 0.5 V, 0.6 V, 0.7 V, or 0.8 V.

A requirement of the nail penetration test may be represented by the number of layers. According to the requirement of the nail penetration test, it may be expected that the nail 10 penetrates a plurality of layers of positive electrode sheets and negative electrode sheets in the battery cell 20. Optionally, the predetermined depth is associated with the number of layers of electrode sheets that need to be penetrated in the nail penetration test. For example, different depths correspond to different numbers of layers. When the number of layers of electrode sheets expected to be penetrated is N1, the predetermined depth is M1; when the number of layers of electrode sheets expected to be penetrated is N2, the predetermined depth is M2; and when the number of layers of electrode sheets expected to be penetrated is N3, the predetermined depth is M3, and so on.

Therefore, the number of layers of electrode sheets expected to be penetrated needs to be converted into a penetration depth, so that a movement distance of the nail 10 is controlled based on the initial insertion position, thereby making the nail penetrate the battery cell 20 to the predetermined depth. In this way, an expected test requirement can be met by using the above method for a nail penetration test.

Certainly, if a requirement of the nail penetration test is represented by a depth, for example, the requirement of the nail penetration test may be that the nail 10 is expected to penetrate the battery cell 20 to the predetermined depth, then after the initial penetration position is determined, the nail 10 is controlled based on the initial penetration position to further move by a corresponding distance. For example, if the predetermined depth is 1.5 mm, the nail 10 is controlled to further move by 1.5 mm from the initial penetration position as the start point. For another example, if the predetermined depth is 2 mm, the nail 10 is controlled to further move by 2 mm from the initial penetration position as the start point.

Therefore, the number of penetration layers and the penetration depth can be converted from each other based on the number of layers of electrode sheets expected to be penetrated and an electrode sheet thickness. For example, the predetermined depth expected to be penetrated may be determined based on the number of layers of electrode sheets expected to be penetrated, a thickness of the first electrode sheet, and a thickness of the second electrode sheet. For another example, the predetermined depth may be determined based on the number of layers, the thickness of the first electrode sheet, and the thickness of the second electrode sheet, in combination with a thickness of a separator between the first electrode sheet and the second electrode sheet and/or a preset gap value.

It can be understood that the number of layers of electrode sheets described in this embodiment of the present application refers to the number of layers of electrode sheet pairs formed by the first electrode sheet and the second electrode sheet, that is, each layer of electrode sheets includes one first electrode sheet and one second electrode sheet. In consideration of an separator, each layer of electrode sheets may include one first electrode sheet, one second electrode sheet, and one separator or two separators.

"Penetration" according to this embodiment of the present application may be understood in a broad sense, and the nail 10 penetrating a certain electrode sheet includes the nail 10 touching and/or penetrating the electrode sheet.

FIG. 4 shows a schematic diagram of an electrode sheet stack of a possible battery cell 20. As shown in FIG. 4, a first electrode sheet 231 and a second electrode sheet 232 are alternately stacked, an electrode sheet at an outermost layer is the second electrode sheet 232, a separator 233 is disposed between the first electrode sheet 231 and the second electrode sheet 232, and an insulating layer 234 is further disposed at the outermost layer. During the movement of the nail 10 toward the battery cell 20, the nail 10 first penetrates the insulating layer 234 at the outermost layer and two separators 233, and the electrode sheets are tightly compressed to a certain extent in this process. Then, the second electrode sheet 232 at the outermost layer is touched or penetrated, and in this process, a voltage change between a first electrode terminal of the battery cell and the nail 10 is detected, so that an initial penetration position is determined based on the voltage change.

Based on the initial penetration position, the nail 10 further moves and sequentially penetrates the first layer of electrode sheets, the second layer of electrode sheets, the third layer of electrode sheets, and so on. As an example, FIG. 4 shows only three layers of electrode sheets, where the first layer of electrode sheets includes one first electrode sheet 231, one second electrode sheet 232, and the separator 233 therebetween. Starting from the second layer of electrode sheets, each layer of electrode sheets includes one first electrode sheet 231, one second electrode sheet 232, and two separators 233, for example, the second layer of electrode sheets and the third layer of electrode sheets shown in FIG. 4.

It should be noted that a definition of the number of layers of electrode sheets in this embodiment of the present application is only an example, and may be appropriately adjusted in practical applications. For example, the first electrode sheet 231 is counted as one layer of electrode sheet, and the second electrode sheet 232 is counted as one layer of electrode sheet. In this case, as shown in FIG. 4, the first layer of electrode sheet includes one second electrode sheet 232, the second layer of electrode sheet includes one first electrode sheet 231 and one separator 233, and the third layer of electrode sheet includes one second electrode sheet 232 and one separator, and so on.

Optionally, the predetermined depth is associated with a thickness of the first electrode sheet of the battery cell and a thickness of the second electrode sheet thereof. Further, the predetermined depth may also be associated with the thickness of the first electrode sheet of the battery cell, the thickness of the second electrode sheet thereof, and a thickness of the separator between the first electrode sheet and the second electrode sheet and/or a preset gap value.

In some embodiments, the predetermined depth may be determined based on the number of layers of electrode sheets that need to be penetrated in the nail penetration test, a thickness of the first electrode sheet 231, and a thickness of the second electrode sheet 232.

Further, in other embodiments, the predetermined depth may be determined based on the number of layers of electrode sheets that need to be penetrated in the nail penetration test, the thickness of the first electrode sheet 231, the thickness of the second electrode sheet 232, and a thickness of the separator 233 between the first electrode sheet 231 and the second electrode sheet 232 and/or a preset gap value D.

In other words, the number of penetration layers and the penetration depth are converted from each other based on the number of layers expected to be penetrated and an electrode sheet thickness. For example, the predetermined depth expected to be penetrated is determined based on the number of layers expected to be penetrated, the thickness of the first electrode sheet 231, the thickness of the second electrode sheet 232, and the thickness of the separator 233 between the first electrode sheet 231 and the second electrode sheet 232 and/or the preset gap value D.

Optionally, when the number of layers of electrode sheets that need to be penetrated is 1, that is, one first electrode sheet 231 and one second electrode sheet 232 are expected to be penetrated, the predetermined depth is L₁, and C+S+D≤L₁≤A+C+S+D. A is the thickness of the first electrode sheet, C is the thickness of the second electrode sheet, S is the thickness of the separator, and D is the gap value.

For example, the above depth range may be mapped based on data such as the first electrode sheet 231, the second electrode sheet 232, and the separator 233 of the battery cell 20 or the number of layers that need to be penetrated, and any value within the depth range may be selected as the predetermined depth, for example, a median value within the depth range may be selected.

Optionally, when the number of layers of electrode sheets that need to be penetrated is N, that is, N first electrode sheets 231 and N second electrode sheets 232 are expected to be penetrated, the predetermined depth is L_{N}, (A+C+S+D)+(A+C+2S)*(N-2)+(C+2S)≤L_{N}≤(A+C+S+D)+(A+C+2S)*(N-1), and N is a positive integer greater than 1.

Since the first electrode sheet 231 and the second electrode sheet 232 of the battery cell 20 are compacted to different degrees after being alternately stacked, a certain gap exists between the electrode sheets, and a magnitude of the gap value D may be determined, for example, based on a manufacturing process. When the nail 10 penetrates the battery cell 20, an electrode sheet is tightly compressed in a penetration region, and certain compensation can be implemented by using the gap value D, thereby improving test accuracy.

For example, if one layer of electrode sheets needs to be penetrated, a penetration depth L₁ of the nail 10 into the battery cell 20 may fall within a range of C+S+D to A+C+S+D; if two layers of electrode sheets need to be penetrated, a penetration depth L₂ of the nail 10 into the battery cell 20 may fall within a range of (A+C+S+D)+(C+2S) to (A+C+S+D)+(A+C+2S); ...; and if N layers of electrode sheets need to be penetrated, a penetration depth L_{N} of the nail 10 into the battery cell 20 may fall within a range of (A+C+S+D)+(A+C+2S)*(N-2)+(C+2S) to (A+C+S+D)+(A+C+2S)*(N-1). In this way, a short circuit can be induced between the first electrode sheet 231 and the second electrode sheet 232 in each layer of electrode sheets, thereby implementing an internal short circuit at a corresponding position in the battery cell 20.

For example, one layer of electrode sheets, that is, the first layer of electrode sheets, needs to be penetrated. As shown in FIG. 4, the first layer of electrode sheets includes the second electrode sheet 232, the separator 233, and the first electrode sheet 231 in sequence from top to bottom. When a penetration depth of the nail 10 into the battery cell 20 is L₁=C+S+D, the nail 10 sequentially penetrates the second electrode sheet 232 at the outermost layer and the separator 233 on a lower surface of the second electrode sheet 232 during the movement and then a tip of the nail 10 contacts an upper surface of the first electrode sheet 231. When a penetration depth of the nail 10 into the battery cell 20 is L₁=A+C+S+D, the nail 10 sequentially penetrates the second electrode sheet 232 at the outermost layer and the separator 233 on the lower surface of the second electrode sheet 232 during the movement, further penetrates the first electrode sheet 231, and then the tip of the nail 10 contacts a lower surface of the first electrode sheet 231. Therefore, when C+S+D≤L₁≤A+C+S+D, the tip may be located at any position in the first electrode sheet 231. In this case, the nail 10 induces a short circuit between the second electrode sheet 232 and the first electrode sheet 231, so that an internal short circuit occurs in the battery cell 20, thereby implementing the nail penetration test.

It can be understood that, in practical applications, as constrained by causes such as the sensitivity of the voltage detection device or a moving rate of the nail 10, the initial penetration position determined based on the above method may have a deviation. For example, when the initial penetration position is determined based on the voltage between the positive electrode terminal and the nail 10, the nail 10 may have already penetrated the second electrode sheet 232 at the outermost layer to a specific depth. Consequently, after the nail 10 further penetrates to the predetermined depth, an actual penetration depth of the nail into the battery cell 10 is slightly greater than the predetermined depth. For example, if one layer of electrode sheets needs to be penetrated, a maximum value L₁ₘₐₓ of a penetration depth of the nail 10 into the battery cell 20 may be slightly greater than A+C+S+D; if two layers of electrode sheets need to be penetrated, a maximum value L₂ₘₐₓ of a penetration depth of the nail 10 into the battery cell 20 may be slightly greater than (A+C+S+D)+(A+C+2S); ...; and if N layers of electrode sheets need to be penetrated, a maximum value L_{Nmax} of a penetration depth of the nail 10 into the battery cell 20 may be slightly greater than (A+C+S+D)+(A+C+2S)*(N-1).

Certainly, such a deviation is acceptable as long as the deviation of the predetermined depth falls within an acceptable range. Generally, the deviation of the predetermined depth does not exceed a preset value P. For example, when the number of layers of electrode sheets that need to be penetrated is 1, the maximum value L₁ₘₐₓ of the predetermined depth meets A+C+S+D≤L₁ₘₐₓ≤A+C+S+D+P; and when the number of layers of electrode sheets that need to be penetrated is N, the maximum value L₂ₘₐₓ of the predetermined depth meets (A+C+S+D)+(A+C+2S)*(N-1)≤Lₙₘₐₓ≤(A+C+S+D)+(A+C+2S)*(N-1)+P. P is the preset value. For example, P may be equal to the thickness of the second electrode sheet 232, or a sum of the thickness of the second electrode sheet 232 and the thickness of the separator 233.

As an example, generally, for a battery cell 10 of an NCM chemical system, thicknesses of a positive electrode sheet, a negative electrode sheet, and a separator (including CCS+PCS) are 0.116 mm, 0.173 mm, and 0.011 mm, respectively; for a battery cell 20 of an LFP chemical system, thicknesses of a positive electrode sheet, a negative electrode sheet, and a separator (including CCS+PCS) are 0.144 mm, 0.172 mm, and 0.0118 mm, respectively; and for a sodium-ion battery cell 20, thicknesses of a positive electrode sheet, a negative electrode sheet, and a separator (including CCS+PCS) are 0.204 mm, 0.205 mm, and 0.0120 mm, respectively.

The thickness of the positive electrode sheet or the negative electrode sheet of the battery cell 20 may be, for example, between 0.1 mm and 0.5 mm, and further, between 0.1 mm and 0.25 mm, where the thickness of the negative electrode sheet may be greater than the thickness of the positive electrode sheet. The thickness of the separator is usually much less than the thicknesses of the positive electrode sheet and the negative electrode sheet. Therefore, in this embodiment of the present application, the separator may be ignored during conversion between the number of layers and a depth.

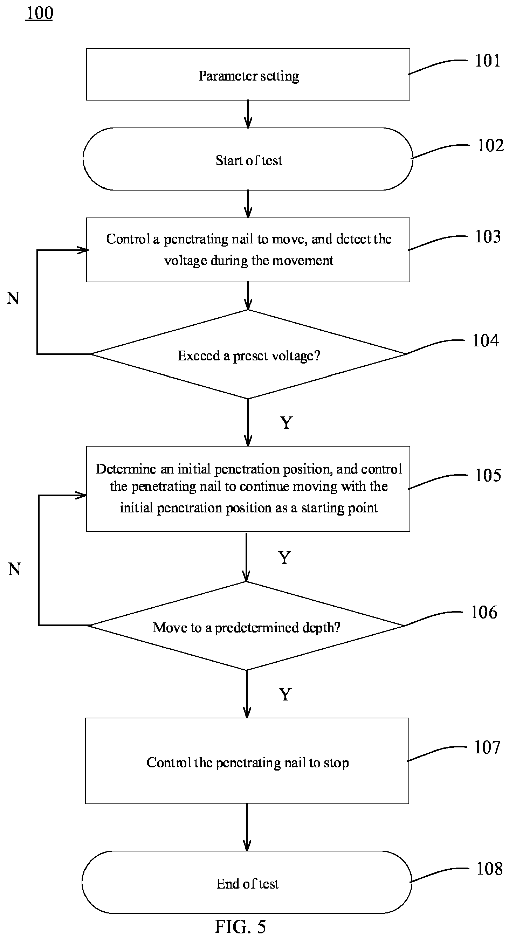

FIG. 5 shows a possible process of the nail penetrate test. For example, this process may be performed by a control module. For example, the control module may be a host, a processor, or the like. In FIG. 5, an electrode sheet at an outermost layer being a negative electrode sheet is used as an example. In this case, the voltage acquisition module 130 is connected between the positive electrode terminal of the battery cell 20 and the nail 10.

As shown in FIG. 5, in step 101, parameters of the nail penetration test are set. For example, parameters such as the preset voltage and the predetermined depth described above are set.

In step 102, it is determined that the nail penetration test starts.

It can be understood that before the nail penetration test is performed, for example, before step 101, operations such as preprocessing, SOC adjustment, and access opening creation may be further performed on the battery cell 20 to be tested.

The preprocessing includes operations such as photographing the battery cell to be tested, testing a voltage, an internal resistance, and a weight, and recording a state of the battery cell 20 before testing. The SOC adjustment may be charging the battery cell to be tested to a predetermined SOC based on a charging manner in a related standard. To make test conditions more stringent, the battery cell 20 may be usually charged to 100% SOC. For example, the battery cell 20 may be charged to a cut-off voltage of the battery cell 20 based on a current of not less than 1/3C, and then is left stationary for 1 to 2 hours, so that the battery cell 20 is in a stable state. Access opening creation refers to that a position on the housing of the battery cell 20 for the nail to penetrate is provided with an avoidance hole having a certain diameter, for example, at least 20 millimeters or at least 10 millimeters, and the avoidance hole can effectively avoid the nail 10, so as to facilitate penetration of the nail 10 into an electrode sheet. A size of the avoidance hole may be slightly greater than a diameter of the nail 10. For example, the diameter of the avoidance hole may be set to about 10 millimeters, for example, be greater than or equal to 10 millimeters. After these operations are completed, the positive electrode terminal of the battery cell 20 and the nail 10 are connected through a voltage line, and the parameters are set. FIG. 4 uses the second electrode sheet at the outermost layer being the negative electrode sheet as an example.

In step 103, the nail mechanism 120 is driven to drive the nail 10 to move along the second direction Y, and the voltage between the nail 10 and the positive electrode terminal of the battery cell 20 is acquired from the voltage acquisition module 130 during the movement.

In step 104, it is determined whether the voltage between the nail 10 and the positive electrode terminal exceeds the predetermined voltage during the movement of the nail 10.

A high-temperature resistant steel nail with an insulating limiting block 52 may be selected as the nail 10. The nail 10 may have a diameter of, for example, 1 mm. The tip may have a conical angle of, for example, 20° to 30°. The nail 10 needs to have a smooth surface without rust, an oxide layer, and oil stain. The moving rate of the nail 10 is, for example, less than or equal to 0.1 mm/s. Values of the parameters such as the diameter and the moving rate of the nail 10 may be selected according to actual conditions, and the present application is not limited thereto.

If the voltage between the nail 10 and the positive electrode terminal exceeds the predetermined voltage, step 105 is performed.

In step 105, the initial penetration position is determined, and the nail is controlled to further move from the initial penetration position as the start point.

For example, a position of the nail 10 at a moment when the voltage between the nail 10 and the positive electrode terminal exceeds the predetermined voltage may be determined as the initial penetration position of the nail 10, and the nail mechanism 120 is driven to drive the nail 10 to further move from the initial penetration position as the start point.

In step 106, it is determined whether the nail 10 has moved to the predetermined depth from the initial penetration position.

If the predetermined depth is reached, step 108 is performed. For example, the predetermined depth is a penetration depth converted from the number of layers expected to be penetrated, or an expected penetration depth such as 2 mm±0.5 mm.

In step 107, the nail mechanism 120 is driven to stop.

Thereafter, a state of the battery cell 20 may be observed. For example, observation is performed at a test environment temperature for a certain time, for example, 1 hour, to determine whether the battery cell 20 has a fire, an explosion, or the like.

In step 108, it is determined that the nail penetration test ends.

The nail 10 is removed, the battery cell 20 is discharged to a specified cut-off voltage, the battery cell 20 is disassembled, and the number of short-circuited layers is recorded.

It can be seen that, with the device 100 in this embodiment of the present application, the initial penetration position of the nail 10 at which the nail 10 touches or penetrates the second electrode sheet at the outermost layer can be accurately determined based on the above process of the nail penetration test, and the nail 10 is controlled to further move based on the initial penetration position, until the nail 10 penetrates the battery cell 20 to the predetermined depth. In this way, the nail penetration test can be precisely and conveniently completed by using a relationship between a physical structure of the battery cell 20 and a voltage without complex modification on the battery cell 20, thereby meeting test requirements for different penetration depths while improving test precision.

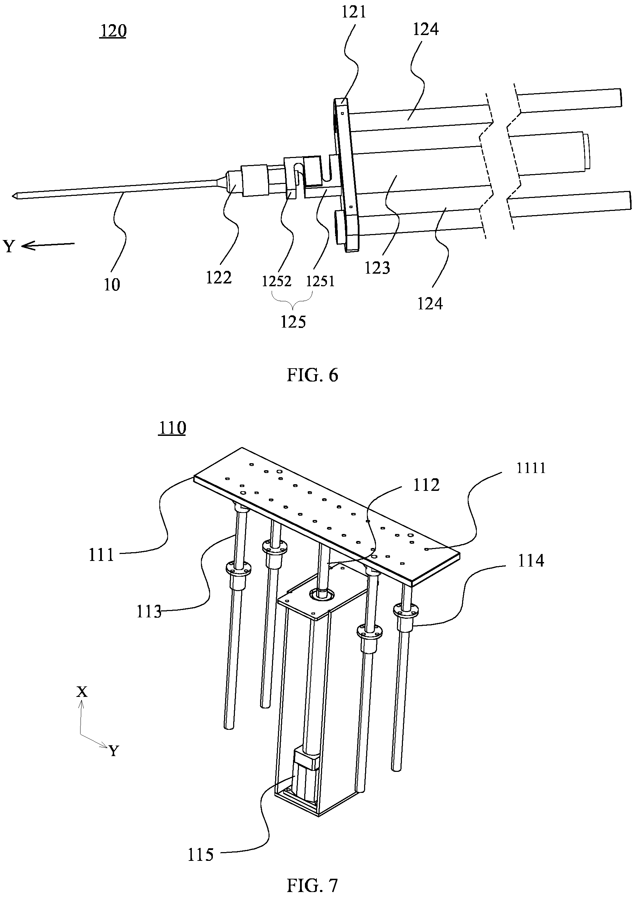

FIG. 6 shows a possible structure of the nail mechanism 120 according to an embodiment of the present application. As shown in FIG. 6, the nail mechanism 120 includes a connecting member 121, a clamping member 122, and a first pushing member 123, the clamping member 122 and the first pushing member 123 are respectively disposed on both sides of the connecting member 121 along the second direction Y, the clamping member 122 is configured to clamp the nail 10, and the first pushing member 123 is disposed to move along the second direction Y to push the connecting member 121, the clamping member 122, and the nail 10 to move along the second direction Y. The first pushing member 123 may be, for example, a push rod disposed parallel to the second direction Y.

The control module may drive the first pushing member 123 to move along the second direction Y, thereby pushing the connecting member 121, the clamping member 122, and the nail 10 to move along the second direction Y toward the battery cell 20.

The clamping member 122 may be, for example, a drill chuck. A front end of the clamping member 122, namely, one end close to the nail 10, is provided with an opening structure. The opening structure may be configured to fix the nail 10. A size of the opening structure is adjustable, so as to be compatible with nails 10 of different diameters, lengths, and materials.

For example, the connecting member 121 may be plate-shaped, for example, may be a flat plate structure made of a steel material, and is provided with a corresponding hole position. The hole position is configured to dispose a fixing member for connecting the clamping member 122, the first pushing member 123, a first guiding member 124, and other components.

In some embodiments, as shown in FIG. 6, the nail mechanism 120 further includes the first guiding member 124, the first guiding member 124 is disposed on a side, of the connecting member 121, on which the first pushing member 123 is located, and the first guiding member 124 is configured to constrain the first pushing member 123 to move along the second direction Y. The first guiding member 124 may be, for example, a guiding rod disposed parallel to the second direction Y.

With the first guiding member 124 disposed for guiding, the first pushing member 123 can be provided with a specific anti-tilting capability, and reliability thereof can be improved, so that the nail 10 can penetrate the battery cell 20 vertically or approximately vertically along the second direction Y, instead of penetrating the battery cell 20 obliquely.

There may be one or more first pushing members 123. For example, FIG. 6 uses one first pushing member 123 as an example. The connecting member 121 and the clamping member 122 are oppositely disposed on both sides of the connecting member 121 along the second direction Y, and the first pushing member 123 and the clamping member 122 are located in a middle region of the connecting member 121.

There may be one or more first guiding members 124. For example, FIG. 6 uses two first pushing members 123 as an example. As shown in FIG. 6, the two first guiding members 124 are disposed on the side, of the connecting member 121, on which the first pushing member 123 is located, and the two first guiding members 124 are respectively located on both sides of the first pushing member 123 to improve uniformity of a constraining force applied to the first pushing member 123.

In some embodiments, as shown in FIG. 6, the nail mechanism 120 may further include a force value sensor 125, which may also be referred to as a force sensor or a pressure sensor. The force value sensor 125 may be disposed between the clamping member 122 and the connecting member 121, and is configured to detect an acting force generated during the penetration of the nail 10 into the battery cell 20.

Disposing the force value sensor 125 in the nail mechanism 120 enables detection of the acting force generated during the penetration of the nail 10 into the battery cell 20, to assist in analyzing a change of an acting force generated by an electrode sheet on the nail 10 during the nail penetration test, thereby expanding a parameter range in the nail penetration test based on a force value change, so that test data analysis is more comprehensive.

The force value sensor 125 may be a sensor of any shape having a force value detection capability. For example, FIG. 6 uses a force value sensor 125 of an "S" shape as an example. The force value sensor 125 includes a first bending portion 1251 and a second bending portion 1252 disposed along the second direction Y, the first bending portion 1251 is connected to the connecting member 121 and can play a supporting role, and the second bending portion 1252 is connected to the clamping member 122 and is configured to receive a force applied to a front end.

The force value sensor 125 is in a state of slight contact with the clamping member 122. When the nail 10 penetrates the battery cell 20, an acting force applied by the battery cell 20 to the nail 10 is transmitted back from the nail 10 and transmitted to the force value sensor 125. The force value sensor 125 acquires a corresponding force value change and transmits the parameter back to the control module or a data acquisition card for recording. Then, the force value data may be used for analysis of a test result and optimization of the test parameters.

In some embodiments, the nail mechanism 120 further includes a first fixing member 126, and the first fixing member 126 is configured to fix the first guiding member 124 to a first wall 141 of a housing 140. Fixing the first guiding member 124 to the first wall 141 of the housing 140 by using the first fixing member 126 enables the first guiding member 124 to accurately constrain the first pushing member 123 to move in the second direction Y.

For example, as shown in FIG. 3 and FIG. 6, the first wall 141 of the housing 140 is perpendicular to a movement direction of the first pushing member 123 of the nail mechanism 120, that is, the second direction Y.

FIG. 7 shows a possible structure of the carrying mechanism 110 according to an embodiment of the present application. As shown in FIG. 7, the carrying mechanism 110 includes a carrying platform 111 and a second pushing member 112, and the second pushing member 112 is disposed to move along the first direction X to push the carrying platform 111 and the battery cell 20 to move along the first direction X. The second pushing member 112 may be, for example, a push rod disposed parallel to the first direction X.

The control module may drive the second pushing member 112 to move along the first direction X, thereby pushing the carrying platform 111 and the battery cell 20 to move along the first direction X.

To adapt to battery cells of different sizes, the carrying platform 111 may be, for example, a lifting platform, which moves in the first direction X, so that the battery cells 20 of different sizes can be located at suitable positions. In this way, the nail 10 can perform penetration at a penetration point position on the battery cells 20.

Optionally, the battery cell 20 further includes an enclosure, the enclosure is configured to accommodate the first electrode sheet and the second electrode sheet, and an avoidance hole is disposed at a position on the enclosure for penetration by the nail 10. The avoidance hole can effectively avoid the nail 10, so as to facilitate penetration of the nail 10 into an electrode sheet.

Before the nail penetration test starts, the battery cell 20 is placed on the carrying platform 111, and the control module may drive the carrying platform 111 to move along the first direction X, so that the nail 10 is aligned with the avoidance hole. In this way, when the nail 10 moves toward the battery cell 20 along the second direction Y, the nail 10 can pass through the avoidance hole and penetrate the battery cell 20. For example, as shown in FIG. 7, the control module may be connected to a motor 115, and control the motor 115 to operate, so as to push the carrying platform 111 to move along the first direction X.

In some embodiments, as shown in FIG. 7, the carrying mechanism 110 further includes a second guiding member 113, the second guiding member 113 is disposed on a side, of the carrying platform 111, on which the second pushing member 112 is located, and the second guiding member 113 is configured to constrain the second pushing member 112 to move along the first direction X. The second guiding member 113 may be, for example, a guiding rod disposed parallel to the first direction X.

With the second guiding member 113 disposed for guiding, the second pushing member 112 can be provided with a specific anti-tilting capability, and reliability thereof can be improved, so that the battery cell 20 is not shifted from the first direction X, thereby enabling the nail 10 to penetrate the battery cell 20 vertically or approximately vertically, instead of penetrating the battery cell 20 obliquely.

There may be one or more second pushing members 112. For example, FIG. 7 uses one second pushing member 112 as an example. The second pushing member 112 is disposed in a middle region of the carrying platform 111.

There may be one or more second guiding members 113. For example, FIG. 7 uses four second guiding members 113 as an example. The four second guiding members 113 are respectively disposed at four corners of the carrying platform 111 to improve uniformity of a constraining force applied to the second pushing member 112.

In some embodiments, the carrying mechanism 110 further includes a second fixing member 114, and the second fixing member 114 is configured to fix the second guiding member 113 to a second wall 142 of the housing 140. Fixing the second guiding member 113 to the second wall 142 of the housing 140 by using the second fixing member 114 enables the second guiding member 113 to accurately constrain the second pushing member 112 to move in the first direction X.

For example, as shown in FIG. 3 and FIG. 7, the second wall 142 of the housing 140 is perpendicular to a movement direction of the second pushing member 112 of the carrying mechanism 110, that is, the first direction X.

In some embodiments, the carrying platform 111 is provided with a hole position 1111, the hole position 1111 is configured to mount a limiting member (not shown in the figure), and the limiting member is configured to limit a position of the battery cell 20. With the hole position 1111 disposed to mount the limiting member, the battery cell 20 can be fixed to the carrying platform 111, thereby improving stability during the nail penetration test.

Due to a huge capacity of the battery cell 20, during the nail penetration test on the battery cell 20, it is possible that risks such as smoke, fire, and even explosion may occur due to failure of the battery cell 20. A high temperature generated during this process may cause a sheet metal of the housing 140 of the device 100 to deform.

In addition, during the nail penetration test, when the battery cell 20 fails, a large amount of smoke and residues may also be generated, and these residues attach to the housing 140 and are difficult to clean up, resulting in an uneven surface of the housing 140. Consequently, the battery cell 20 may slip or experience other conditions during the test, which affects a test result.

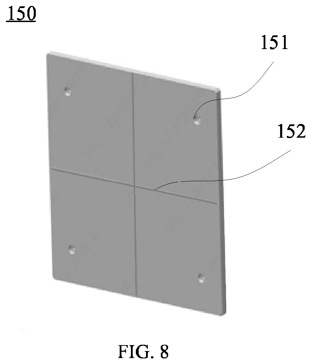

Therefore, in some embodiments, as shown in FIG. 3 and FIG. 8, the device 100 may further include a protective panel 150, and the protective panel 150 is disposed between the battery cell 20 and a third wall 143 of the housing 140. In this way, the protective panel 150 may serve as a "sacrificial component", thereby reducing impact of the nail penetration test on the housing 140 and extending a service life of the device 100.

As shown in FIG. 3 and FIG. 8, the protective panel 150 is disposed between the battery cell 20 and the third wall 143 of the housing 140. The third wall 143 may be, for example, perpendicular to the second direction Y. The protective panel 150 can protect the third wall 143, of the housing 140, that is close to the battery cell 20, so that emissions such as residues and smoke generated by the battery cell 20 during the test can be prevented from being attached to the third wall 143 to some extent, thereby reducing damage to the third wall 143.

The protective panel 150 may be located on a side of the carrying platform 111, but not in contact with the carrying platform 111.

For example, the protective panel 150 and the third wall 143 may be detachably connected to facilitate replacement of the protective panel 150.

In some embodiments, as shown in FIG. 8, the protective panel 150 is provided with a counterbore 151, the counterbore 151 is configured to dispose a fixing member (not shown in the figure), and the fixing member is configured to fix the protective panel 150 to the third wall 143. Designing the counterbore 151 is beneficial to reducing a probability of interference between the protective panel 150 and the battery cell 20, thereby implementing the test for a battery cell 20 with a relatively large volume.

For example, the fixing member may be a screw. As shown in FIG. 8, the protective panel 150 may be locked to the third wall 143 by using four screws. A thickness of the protective panel 150 may be, for example, from 15 millimeters to 25 millimeters, for example, 20 millimeters. A length and a width of the protective panel 150 may be from 300 millimeters to 400 millimeters. For example, a size of the protective panel 150 may be 400 millimeters × 300 millimeters.

In some embodiments, the protective panel 150 is provided with an engraved mark 152, for example, a cross engraved mark shown in FIG. 8, and the engraved mark 152 is configured to position the battery cell 20. The visible engraved mark 152 on the protective panel 150 facilitates positioning of the battery cell 20. This helps testing personnel determine a positional relationship between the battery cell 20 and the protective panel 150, for example, determine whether the battery cell 20 is roughly located in a central region of the protective panel 150.

It can be seen from the above description that the nail penetration test device 100 according to the embodiments of the present application includes the carrying mechanism 110, the nail mechanism 120, and the voltage acquisition module 130. The carrying mechanism 110 can carry the battery cell 20 to be tested and drive the battery cell 20 to move in the first direction X. The nail mechanism 120 can control the nail 10 to move toward the battery cell 20 along the second direction Y. During the movement of the nail 10, the voltage acquisition module 130 detects the voltage between the nail 10 and an electrode terminal connected to the first electrode sheet. When the nail 10 touches or penetrates the second electrode sheet at the outermost layer, the voltage acquisition module 130 can detect that the voltage between the nail 10 and the electrode terminal has changed significantly. Therefore, the initial penetration position of the nail 10 on the battery 20 may be determined based on a change of the voltage between the nail 10 and the electrode terminal, and the initial penetration position is used as a start point to control the nail 10 to further move inside the battery cell 20 to the predetermined depth. In this way, with the device 100, the initial penetration position of the nail 10 on the battery cell 20 can be accurately determined by using the relationship between the physical structure of the battery cell 20 and a voltage without complex modification on the battery cell 20, thereby completing the nail penetration test, and meeting test requirements for different penetration depths while improving test precision.

It should be noted that, under the premise of no conflict, the embodiments described in the present application and/or the technical features in the embodiments may be arbitrarily combined with each other, and the technical solution obtained after the combination should also fall within the scope of protection of the present application.

Those of ordinary skill in the art may realize that the units and algorithm steps of each example described in conjunction with the embodiments disclosed herein may be implemented in electronic hardware, or a combination of computer software and electronic hardware. Whether these functions are performed in hardware or software depends on the particular application and design constraints of the technical solution. Skilled artisans may use different methods to implement the described functions for each particular application, but such implementation should not be considered beyond the scope of the present application.

In several embodiments provided in the present application, it should be understood that the disclosed systems, devices, and methods may be implemented in other ways. For example, the device embodiments described above are merely illustrative. For example, the division of the units is merely a logical function division, and there may be other division manners in actual implementation. For example, a plurality of units or assemblies may be combined or may be integrated into another system, or some features may be ignored or not performed. On the other hand, the mutual coupling or direct coupling or communication connection shown or discussed may be through some interfaces, and the indirect coupling or communication connection between the devices or units may be in an electrical, mechanical or other forms.

The units described as separate components may or may not be physically separated, and the components shown as units may or may not be physical units, that is, may be located in one place, or may be distributed over a plurality of network units. Some or all of the units may be selected according to actual requirements to achieve the purpose of the solutions of the embodiments of the present application.

## Claims

1. A nail penetration test device, **characterized by** comprising:
a voltage acquisition module, comprising a first connection port and a second connection port, wherein the first connection port is connected to a nail, and the second connection port is connected to a first electrode terminal of a battery cell; and
a nail mechanism, configured to control the nail to move toward the battery cell, wherein the voltage acquisition module is configured to detect a voltage between the nail and the first electrode terminal during the movement of the nail toward the battery cell, and the voltage is used to determine an initial penetration position of the nail on the battery cell.

2. The device according to claim 1, wherein the battery cell comprises a first electrode sheet and a second electrode sheet alternately stacked with each other, an electrode sheet at an outermost layer is the second electrode sheet, the first electrode sheet and the second electrode sheet have opposite polarities, the first electrode terminal is an electrode terminal connected to the first electrode sheet, and the voltage is used to determine the initial penetration position of the nail on the battery cell.

3. The device according to claim 1 or 2, further comprising:
a carrying mechanism, configured to carry a battery cell to be tested, and adjust a position of the battery cell in a first direction;
wherein the nail mechanism is specifically configured to control the nail to move toward the battery cell along a second direction, and the second direction is perpendicular to the first direction.

4. The device according to claim 3, wherein the nail mechanism comprises a connecting member, a clamping member, and a first pushing member, the clamping member and the first pushing member are respectively disposed on both sides of the connecting member along the second direction, the clamping member is configured to clamp the nail, and the first pushing member is disposed to move along the second direction to push the connecting member, the clamping member, and the nail to move along the second direction.

5. The device according to claim 4, wherein the nail mechanism further comprises a first guiding member, the first guiding member is disposed on a side, of the connecting member, on which the first pushing member is located, and the first guiding member is configured to constrain the first pushing member to move along the second direction.

6. The device according to claim 5, further comprising a housing, wherein the nail mechanism further comprises a first fixing member, the first fixing member is configured to fix the first guiding member to a first wall of the housing, and the first wall is perpendicular to the second direction.

7. The device according to claim 4, wherein the nail mechanism further comprises a force value sensor, and the force value sensor is disposed between the clamping member and the connecting member, and is configured to detect an acting force generated during the penetration of the nail into the battery cell.

8. The device according to claim 7, wherein the force value sensor comprises a first bending portion and a second bending portion that are disposed along the second direction, the first bending portion is connected to the connecting member, and the second bending portion is connected to the clamping member.

9. The device according to claim 3, wherein the carrying mechanism comprises a carrying platform and a second pushing member, and the second pushing member is disposed to move along the first direction to push the carrying platform and the battery cell to move along the first direction.

10. The device according to claim 9, wherein the carrying mechanism further comprises a second guiding member, the second guiding member is disposed on a side, of the carrying platform, on which the second pushing member is located, and the second guiding member is configured to constrain the second pushing member to move along the first direction.

11. The device according to claim 10, further comprising a housing, wherein the carrying mechanism further comprises a second fixing member, the second fixing member is configured to fix the second guiding member to a second wall of the housing, and the second wall is perpendicular to the first direction.

12. The device according to claim 9, wherein the carrying platform is provided with a hole position, the hole position is configured to mount a limiting member, and the limiting member is configured to limit a position of the battery cell.

13. The device according to claim 1 or 2, further comprising a housing and a protective panel, wherein the protective panel is disposed between the battery cell and a third wall of the housing, and the third wall is perpendicular to the second direction.

14. The device according to claim 13, wherein the protective panel is detachably connected to the third wall.

15. The device according to claim **14,** wherein the protective panel is provided with a counterbore, the counterbore is configured to dispose a fixing member, and the fixing member is configured to fix the protective panel and the third wall.

16. The device according to claim 15, wherein the protective panel is provided with an engraved mark, and the engraved mark is configured to position the battery cell.

17. The device according to claim 1 or 2, wherein the battery cell further comprises an enclosure, the enclosure is configured to accommodate the first electrode sheet and the second electrode sheet of the battery cell, and an avoidance hole is disposed at a position on the enclosure for penetration by the nail.

18. The device according to claim 1 or 2, further comprising:
a control module, connected to the voltage acquisition module and the nail mechanism, and configured to determine the initial penetration position based on the voltage, and based on the initial penetration position, drive the nail mechanism to control the nail to move toward the battery cell, so that the nail penetrates the battery cell to a predetermined depth.
